## Europäisches Patentamt
## European Patent Office
## Office européen des brevets

(19)

(11) Numéro de publication: **0 002 640**
**A1**

(12)

# DEMANDE DE BREVET EUROPEEN

(21) Numéro de dépôt: **78400226.3**

(22) Date de dépôt: **11.12.78**

(51) Int. Cl.²: **H 04 B 1/12**
**H 03 F 3/26**

(30) Priorité: **19.12.77 FR 7738252**

(43) Date de publication de la demande:
**27.06.79 Bulletin 79/13**

(84) Etats contractants désignés:
**DE GB IT NL**

(71) Demandeur: **"THOMSON-CSF"**
**173, boulevard Haussmann**
**F-75360 Paris Cedex 08(FR)**

(72) Inventeur: **Menant, Christophe**
**"THOMSON-CSF" - SCPI 173, bld Haussmann**
**F-75360 Paris Cedex 08(FR)**

(72) Inventeur: **Meyer, Armand**
**"THOMSON-CSF" - SCPI 173, bld Haussmann**
**F-75360 Paris Cedex 08(FR)**

(72) Inventeur: **Rotteleur, Laurent**
**"THOMSON-CSF" - SCPI 173, bld Haussmann**
**F-75360 Paris Cedex 08(FR)**

(74) Mandataire: **Blaise, Michel et al,**
**"THOMSON-CSF" - SCPI 173, bld Haussmann**
**F-75360 Paris Cedex 08(FR)**

(54) **Etage d'entrée de récepteur protégé contre les signaux brouilleurs, et récepteur utilisant un tel étage.**

(57) La présente invention concerne les étages d'entrée de récepteur.

Elle consiste à réaliser ces étages symétriquement en classe AB, avec un point de polarisation choisi pour assurer un fonctionnement linéaire en classe A jusqu'à un niveau au plus égal à celui du signal utile le plus fort à recevoir.

Application aux récepteurs destinés à recevoir des signaux parasites de fort niveau, en particulier les récepteurs montés sur véhicules mobiles.

EP 0 002 640 A1

•/• ••

Fig_1

1

## ÉTAGE D'ENTRÉE DE RECEPTEUR PROTÉGÉ CONTRE LES SIGNAUX BROUILLEURS, ET RECEPTEUR UTILISANT UN TEL ETAGE

La présente invention concerne les étages d'entrée de récepteur , destinés à recevoir des signaux utiles de très faibles niveaux en présence de signaux parasites de niveau supérieur à ces signaux utiles, et les récepteurs comportant de tels étages d'entrée.

Il est connu que la réception de signaux faibles dans un champ perturbateur intense créé, par exemple, par l'émetteur local d'une liaison duplex, nécessite des dispositions particulières dans les circuits d'amplification d'entrée des récepteurs afin d'obtenir une linéarité suffisante pour les signaux forts et d'éviter, ainsi, une modulation de leur gain au rythme du brouilleur d'où résulte une baisse de sensibilité du récepteur, accompagnée de transmodulation, et d'un risque d'intermodulation.

Les solutions connues ont pour base commune un amplificateur d'entrée de réception de forte dynamique polarisé en classe A avec un fort courant de repos.

Les défauts ci-dessus sont ainsi éliminés ou fortement réduits, mais au prix d'une forte consommation, entraînant un facteur de bruit élevé.

Ces inconvénients sont particulièrement gênants

2

si l'intensité du champ perturbateur n'est importante que pendant une partie du temps d'exploitation des équipements.

La présente invention a pour objet de les pallier.

L'étage d'entrée selon l'invention est caractérisé en ce qu'il comporte un étage symétrique équipé de deux transistors de même type, fonctionnant en classe A lors de la réception des seuls signaux utiles et en classe AB en présence de signaux parasites de niveau supérieur au niveau maximal de ces signaux utiles.

L'invention sera mieux comprise et d'autres caractéristiques apparaîtront à l'aide de la description ci-après et des dessins s'y rapportant sur lesquels :

- la figure 1 est un schéma de principe d'un exemple d'étage d'entrée de récepteur, selon l'invention ;

- la figure 2 est un diagramme explicatif du fonctionnement de la figure 1.

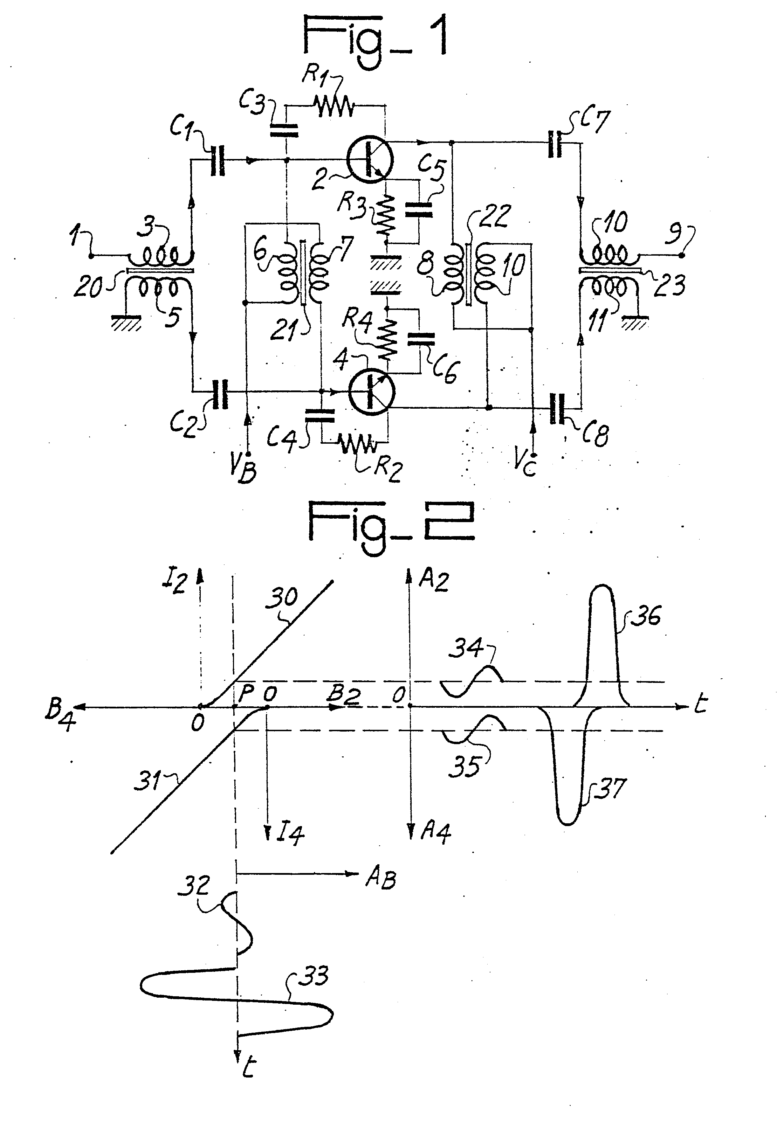

Sur la figure 1, une borne d'entrée 1, à laquelle sont appliqués les signaux reçus par un aérien, non représenté, est connectée à la base d'un transistor 2 à travers un enroulement 3 en série avec un condensateur $C_1$. Cet enroulement 3 est couplé à un autre enroulement 5 dont une extrémité est reliée à la masse et l'autre à la base d'un transistor 4 à travers un condensateur $C_2$. La base du transistor 2 est en outre connectée d'une part, à son collecteur à travers un condensateur $C_3$ en série avec une résistance $R_1$, d'autre part à une source de tension $V_B$ à travers un enroulement 6. De même la base du transistor 4 est en outre connectée, d'une part, à son collecteur à travers un condensateur $C_4$ en série avec une résistance

$R_2$ d'autre part à la source de tension $V_B$ à travers un enroulement 7.

Les émetteurs des transistors 2 et 4 sont respectivement connectés à la masse à travers des résistances découplées $R_3$ $C_5$ et $R_4$ $C_6$. Le collecteur du transistor 2 est en outre connecté d'une part à une source de tension $V_C$ à travers un enroulement 8 et d'autre part à une borne de sortie 9 à travers un condensateur $C_7$ en série avec un enroulement 10. De même le collecteur du transistor 4 est en outre connecté d'une part à la source de tension $V_C$ à travers un enroulement 10 et d'autre part à la masse à travers un condensateur $C_8$ en série avec un enroulement 11.

Les quatre couples d'enroulements 3-5, 6-7, 8-10 et 10-11 constituant des transformateurs de rapport 1 de repère général respectif : 20, 21, 22, 23. Le transformateur 20 assure, à travers les impédances d'entrée des transistors 2 et 4, une alimentation symétrique des bases de ces derniers, et le transformateur 23, une addition en phase des signaux fournis par chaque transistor. Les enroulements des transformateurs 21 et 22 jouent essentiellement le rôle de selfs de blocage.

Les condensateurs $C_1$ à $C_8$ ont pour but d'assurer un découplage vis-à-vis des diverses polarisations. Ils sont déterminés pour présenter une réactance négligeable aux fréquences des signaux amplifiés par ce montage.

Les transistors 2 et 4 sont identiques entre eux. D'autre part des valeurs identiques sont données à $R_1$ et $R_2$, de même à $R_3$ et $R_4$, afin d'assurer la symétrie du montage.

Le fonctionnement sera décrit à l'aide des diagrammes de la figure suivante.

Sur la figure 2, la courbe 30 représente le courant collecteur $I_2$ du transistor 2 en fonction de sa ten-

4

sion émetteur-base $B_2$ ; de même la courbe 31 représente le courant collecteur $I_4$ du transistor 4 en fonction de sa tension émetteur-base $B_4$.

Les courbes ont été représentées avec des ordonnées opposées et des abscisses également opposées mais décalées de manière à avoir pour point commun une tension de polarisation P qui est le point de repos commun des deux transistors.

Les courbes 32 et 33 représentent l'amplitude $A_B$ en fonction du temps t de deux échantillons de signaux appliqués symétriquement sur la base des transistors 2 et 4 par rapport à ce point P.

Les courbes 34 et 35 représentent en fonction du temps, respectivement, les amplitudes $A_2$ et $A_4$ des courants collecteurs des transistors correspondants 2 et 4 en réponse au signal 32, et les courbes 36 et 37, celles correspondant au signal 33.

Le signal faible 32 module la tension de polarisation base émetteur dans la région linéaire de la caractéristique de chaque transistor, c'est-à-dire en classe d'amplification A, les deux transistors ayant une réponse identique représentée par les signaux 34 et 35, apparemment en phase sur la figure mais en réalité en opposition par suite du sens opposé des ordonnées auxquels ils se rapportent. Ces signaux sont additionnés sur la sortie 9 par une disposition relative adéquate du sens des enroulements du transformateur 23.

Le signal fort 33 entraîne un fonctionnement en classe AB de l'amplificateur. Chaque transistor ne répond ainsi essentiellement qu'à une alternance du signal, mais par des signaux 36 et 37 symétriques dont la résultante des deux, réalisée dans le transforma-

5

teur 23, est proportionnelle au signal 33 si les transistors 4 et 5 sont identiques et identiquement polarisés.

Le choix du point de repos P est déterminé de manière à être à la limite du fonctionnement linéaire en classe A pour le signal utile reçu au niveau le plus élevé, c'est celui qui est sensiblement représenté par le signal 32.

Dans ces conditions, l'étage d'entrée ainsi constitué présente, en l'absence de signal brouilleur, un courant de consommation faible et un bon facteur de bruit, en même temps qu'une excellente linéarité. En présence de brouilleurs de niveau varié, la linéarité reste bonne, il n'y a donc pas à craindre la création de transmodulation ou de produits d'intermodulation, comme c'est le cas des étages d'entrée conventionnels qui sont généralement un compromis très imparfait entre les performances de facteur de bruit, de consommation, et de linéarité aux signaux élevés.

Le facteur de bruit du montage décrit augmente inéluctablement en même temps que le niveau des signaux brouilleurs, mais cette augmentation se trouve adaptée à ce niveau. Le récepteur est donc placé dans de très bonnes conditions de réception pour tout niveau de brouilleur.

1

## REVENDICATIONS

1. Etage d'entrée de récepteur destiné à recevoir des signaux faibles dans un champ parasite intense, caractérisé en ce qu'il comporte un étage d'amplification symétrique comportant deux transistors (2 et 4) de même type.

2. Etage d'entrée selon la revendication 1 caractérisé en ce que le point de fonctionnement (P de l'étage d'amplification symétrique est déterminé de manière à obtenir un courant collecteur minimal compatible avec un fonctionnement linéaire en classe A de chacun des deux transistors (2 et 4) pour tout niveau de signal utile à recevoir, le fonctionnement correspondant à celui d'un amplificateur en classe AB pour les niveaux de signal brouilleur supérieurs au niveau maximal de signal utile.

3. Etage d'entrée selon l'une des revendications 1 et 2, caractérisé en ce que les deux transistors (2 et 4) sont montés en émetteur commun.

4. Récepteur caractérisé en ce qu'il comporte un étage d'entrée selon l'une des revendications précédentes.

# Fig_1

# Fig_2

0002640

## DOCUMENTS CONSIDERES COMME PERTINENTS

| Catégorie | Citation du document avec indication, en cas de besoin, des parties pertinentes | Revendication concernée |
|---|---|---|
| | FR - A - 2 294 586 (WESTERN ELECTRIC)<br><br>* Page 2, lignes 28-35; page 4, ligne 9 - page 5, ligne 5 *<br><br>-- | 1-3 |
| | FR - A - 2 105 230 (MARCONI)<br><br>* Page 1, lignes 13-16 *<br><br>-- | 1-3 |
| | FUNKSCHAU, vol. 45, no. 2, 19 janvier 1973, München (DE) ROHDE et EICHEL: "Stand der Technik bei Amateurfunkgeräten im Kurzwellengebiet", pages 57-59.<br><br>* Page 57, colonne de droite, lignes 10-13; figure 25 *<br><br>-- | 1-4 |
| | HAM RADIO, Octobre 1976, U.S.A. ROHDE: "Optimum design for high-frequency communications receivers" pages 10-25.<br><br>* Figure 14; page 21, colonne de droite, ligne 9 et page 23, colonne de gauche, lignes 1-6 *<br><br>-- | 1-4 |
| | DE - B - 1 182 302 (MAIHAK)<br><br>* Colonne 4, lignes 15-27 *<br><br>-- | 1,3 |
| | QST (amateur radio), Vol. 57, no. 9, sept. 1973 Newington, U.S.A.<br>./. | 1,3 |

**CLASSEMENT DE LA DEMANDE (Int. Cl.³)**

H 04 B 1/12
H 03 F 3/26

**DOMAINES TECHNIQUES RECHERCHES (Int. Cl.³)**

H 04 B
H 03 F

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 23-03-1979 | THOMAES |

OEB Form 1503.1  06.78

r002640

| DOCUMENTS CONSIDERES COMME PERTINENTS | | | CLASSEMENT DE LA DEMANDE (Int. Cl.²) |
|---|---|---|---|
| Catégorie | Citation du document avec indication, en cas de besoin, des parties pertinentes | Revendica-tion concernée | |
| | MANON: "An HF-Band Solid-State Amplifier" pages 18-23 et 57.<br><br>   * Figure 13 et page 23,<br>     deuxième alinéa *<br><br>     -- | | |
| | WIRELESS WORLD, vol. 83, no. 1497 Mai 1977, Haywards Heath Sussex GB GRANBERG: "Two-stage h.f. linear amplifier" pages 67-70<br><br>   * Figure 5; page 69, colonne<br>     de droite, deuxième alinéa *<br><br>     -- | 1,3 | DOMAINES TECHNIQUES RECHERCHES (Int. Cl.²) |
| | FUNKSCHAU, vol. 34, no. 2, 1 février 1962, München DE "Mesa Transistoren für hohe Frequenzen" page 46<br><br>   * Figure 2 *<br><br>     -- | 1,3 | |
| | WIRELESS WORLD, vol. 81, no. 1477 september 1975, Haywards Heath Sussex, GB O'REILLY: "Transmitter power amplifier Design-1" pages 417-422<br><br>   * Figure 3, page 420, colonne<br>     de gauche, lignes 30-44 *<br><br>     ---- | 1,3 | |